# EUROPÄISCHE PATENTSCHRIFT

(11) **EP 2 870 695 B1**
(45) Veröffentlichungstag und Bekanntmachung des Hinweises auf die Patenterteilung: **22.06.2016**
(21) Anmeldenummer: 13734720.9
(22) Anmeldetag: 02.07.2013
(51) Int. Cl.: H03K 17/975, H03K 17/96, G06F 3/041, G06F 3/044

(54) **BERÜHRUNGSEMPFINDLICHE BEDIENEINHEIT MIT ROTIERENDER BERÜHRSCHICHT**
TOUCH-SENSITIVE OPERATING UNIT WITH ROTATING TOUCH LAYER
UNITÉ DE COMMANDE TACTILE AVEC COUCHE TACTILE TOURNANTE

(30) Priorität: 09.07.2012 DE 102012211935
(43) Veröffentlichungstag der Anmeldung: 13.05.2015
(73) Patentinhaber: PREH GmbH, 97616 Bad Neustadt a.d. Saale (DE)
(72) Erfinder: BAUER, Norbert, 97072 Würzburg (DE); KLEFFEL, Thomas, 97204 Höchberg (DE)
(74) Vertreter: Patentanwälte Bauer Vorberg Kayser
(86) Internationale Anmeldenummer: PCT/EP2013/063935
(87) Internationale Veröffentlichungsnummer: WO 2014/009206

(56) Entgegenhaltungen:
- WO-A1-2010/000281
- WO-A1-2011/048109

## Beschreibung

Die vorliegende Erfindung betrifft ein Verfahren zur Kalibrierung eines berührempfindlichen Sensors, wobei der Sensor eine erste Berührfläche ausbildende Berührschicht und Mittel zur Erzeugung eines elektrischen Feldes im Bereich der ersten Berührfläche aufweist, um einen dem elektrischen Feld zugehörigen Induktivitäts- und/oder Kapazitätssignalwert mittels des Sensors zu erzeugen, und wobei die Berührschicht und die Mittel zur Erzeugung eines elektrischen Feldes relativ zueinander bewegbar sind. Berührungsempfindliche Eingabegeräte mit mehreren, in einem array angeordneten Sensoren sind weitläufig als sogenanntes Touchpad oder in Kombination mit einem darunter liegenden Bildschirm als Touchscreen bekannt. Kapazitive Touchpads ermitteln anhand der elektrischen Kapazität die Position des Fingers auf der Berührfläche des Pads und ordnen somit zum Beispiel den Ort des Cursors (Mauszeigers) auf einem zugeordneten Bildschirm zu. Dies kann durch verschiedene Bauweisen geschehen. Üblicherweise ist unterhalb der Berührschicht eine Anordnung von vertikalen und horizontalen Elektroden, die ein Gitter bilden, vorgesehen. Dieses Gitter ist mit einer isolierenden Berührschicht überzogen, die dafür sorgt, dass man die Elektroden nicht berührt und der Finger gut über die Oberfläche gleitet. Elektrisch verbunden mit diesem Gitter ist eine elektronische Auswerteinheit, die ständig die Kapazität zwischen den Elektroden misst. Kommt man nun mit dem Finger, der - durch seinen Wassergehalt - ebenfalls eine Art Elektrode ist, in die Nähe dieser Anordnung, wird die Kapazität zwischen den Elektroden verändert. Dadurch kann die Position unabhängig von der Stärke des Drucks ermittelt werden. Nach Auswertung wird die Information beispielsweise als Cursorposition an einen Computer weitergeleitet. Bei dem Wunsch, eine berührungsempfindliche Eingabemöglichkeit in eine Bedieneinheit mit bewegbarem Bedienteil zu integrieren, stößt der Konstrukteur auf die Schwierigkeit, das mit dem Bedienteil bewegte Touchpad elektrisch kontaktieren zu müssen. Ferner ist das Bauvolumen eines Touchpads vergleichsweise voluminös und schlecht in die in der Regel an die Handabmessung angepassten Bauformen der Bedienteile zu integrieren. Ferner ist es bekannt, dass die Eingabegenauigkeit von berührungsempfindlichen Eingabegeräten stark mit den Umgebungsbedingungen und Aufbauveränderungen variiert. Das Dokument WO2010/000281 A1 offenbart eine Bedieneinheit , aufweisend einen berührempfindlichen Sensor, wobei der Sensor eine erste Berührungsfläche ausbildende Berührschicht und Mittel zur Erzeugung eines elektrischen Feldes im Bereich der ersten Berührfläche aufweist, um einen dem elektrischen Feld zugehörigen Induktivitäts- und/oder Kapazitätssignalwert mittels des Sensors zu erzeugen, und wobei die Berührschicht und die Mittel zur Erzeugung eines elektrischen Feldes relativ zueinander bewegbar sind; ferner aufweisend eine Detektionseinrichtung, um eine Relativbewegung zwischen den Mitteln zur Erzeugung eines elektrischen Feldes und der Berührschicht zu detektieren, sowie eine Auswerteinheit, die ausgelegt ist, den Signalwert des Sensors mittels eines vorgespeicherten Schwellwertes auszuwerten, um eine Berührung der ersten Berührfläche zu detektieren. Es ist dem Verdienst der vorliegenden Erfinder zuzurechnen, dieses Hindernis überwunden zu haben und eine Lösung für das Problem gefunden zu haben, das sich ergibt, wenn die Komponenten des berührungsempfindüchen Eingabegeräts relativ zueinander bewegt werden. Aufgabe der Erfindung ist es daher, eine bauraumsparende, insbesondere eine elektronisch einfach zu kontaktierende Anordnung für eine Bedieneinheit mit berührungsempfindlichem Sensor bei gleichzeitiger Gewährleistung eines zuverlässigen und sicheren Betriebs bereitzustellen. Ein entsprechend vorteilhaftes Betriebsverfahren ist ebenfalls Gegenstand der vorliegenden Erfindung. Die zuvor genannte Aufgabe wird mit den Gegenständen des Hauptanspruchs sowie denen der nebengeordneten Patentansprüche gelöst. Die jeweils abhängigen Ansprüche betreffen vorteilhafte Ausgestaltungen.

Die Erfindung betrifft ein Verfahren zum Betrieb eines berührempfindlichen Sensors, wobei der Sensor eine erste Berührfläche ausbildende Berührschicht und Mittel zur Erzeugung eines elektrischen Feldes im Bereich der ersten Berührfläche aufweist, um einen dem elektrischen Feld zugehörigen Induktivitäts- und/oder Kapazitätssignalwert mittels des Sensors zu erzeugen. Erfindungswesentlich für das erfindungsgemäße Verfahren ist, dass die Berührschicht und die Mittel zur Erzeugung eines elektrischen Feldes relativ zueinander, beispielsweise translatorisch und/oder rotatorisch, bewegbar sind. Bevorzugt ruhen die Mittel zur Erzeugung des elektrischen Feldes, wobei die Berührschicht drehbar gelagert ist. Das erfindungsgemäße Verfahren umfasst die folgenden Schritte. Es erfolgt eine Überwachung auf Detektion einer Relativbewegung zwischen den Mitteln zur Erzeugung eines elektrischen Feldes und der Berührschicht mittels einer Detektionseinrichtung. Sofern die Relativbewegung detektiert wird, gegebenenfalls unter Berücksichtigung einer Toleranzschwelle des Bewegungsmaßes, und bevorzugt aber nicht zwingend nach Abschluss der Relativbewegung, also bevorzugt erst wieder im Ruhezustand, wird ein Kalibrierverfahren durchgeführt. Das Kalibrieren umfasst die folgenden Schritte: Ermitteln des dem elektrischen Feld zugehörigen Induktivitäts- und/oder Kapazitätssignalwertes mittels einer Auswerteinheit, Vergleich des Signalwertes mit einem vorgespeicherten Schwellwert mittels der Auswerteinheit; Speichern des ermittelten Signalwertes als neuer Schwellwert mittels der Auswerteinheit, sofern wenigstens der gemessene Messwert in einen vorgegebenen Bereich um den vorgespeicherten Schwellwert fällt, ansonsten wird beispielsweise der vorgespeicherte Schwellwert beibehalten. Das nachfolgende Auswerten des Signalwertes des Sensors, um eine Berührung der ersten Berührfläche zu detektieren, erfolgt mittels des vorgespeicherten gegebenenfalls mittels des unmittelbar vorher gespeicherten Schwellwertes bis zur erneuten Detektion einer Relativbewegung durch die Auswerteinheit.

Der erfindungsgemäße Sensor umfasst Mittel zur Erzeugung eines elektrischen Feldes, beispielsweise eine oder mehrere Elektroden oder/oder eine Spule. Der erfindungsgemäße Sensor umfasst ferner eine Auswertschaltungsanordnung zur Ermittlung wenigstens einer Änderung der durch das elektrische Feld begründeten Induktivität und/oder Kapazität. Die Erfindung ist hinsichtlich des Sensors nicht eingeschränkt. Beispielsweise handelt es sich um einen kapazitiven Sensor. So ist es bekannt, aus der Variation der Umladedauer einer Ladung des durch das Messfeld definierten Messkondensators auf einen Referenzkondensator eine Kapazitätsänderung zu ermitteln. Bei auf Amplitudenmodulation basierter Auswertung wird das Messfeld mit hochfrequentem Wechselstrom (z. B. 20 kHz) gespeist und der resultierende Blindstrom erfasst. Bei Auswertung mittels Frequenzmodulation wird das kapazitive Messfeld mit einer Induktivität zu einem Schwingkreis zusammengeschaltet, dessen Resonanzfrequenz gemessen werden kann - üblicherweise als Frequenzverschiebung bei dynamischen Vorgängen.
Die Auswertschaltungsanordnung umfasst beispielsweise wenigstens einen Mikrocontroller.

Die Relativbewegung zwischen der Berührschicht und den Felderzeugungsmitteln kann beispielsweise mittels Aktuator erfolgen. Bevorzugt ist eine händisch betätigte Relativbewegung vorgesehen.

Erfindungsgemäß umfasst das erfindungsgemäße Verfahren auch die Verwendung mehrerer Sensoren, wie eine räumliche Anordnung (Array) von Sensoren zur ortsauflösenden Erfassung der Berührung, beispielsweise ein touchpad oder ein touchscreen.

Das erfindungsgemäß Betriebsverfahren zeichnet sich dadurch aus, dass nach erfolgter Detektion einer Relativbewegung zwischen den Mittel zur Erzeugung eines elektrischen Feldes (Messfeldes) und der Berührfläche eine Kalibrierung durchgeführt wird. Während die erfindungsgemäß eingeräumte Relativbewegung zwischen den Komponenten den gestalterischen und konstruktiven Freiraum verbessert und ferner bei ruhenden Felderzeugungsmitteln die Frage deren elektrischer Kontaktierung vereinfacht, so stellen die erfindungsgemäßen Kalibrierschritte die Funktionssicherheit sicher, da bei einer Relativbewegung, selbst wenn Sie im Wesentlichen in einer Ebene gleicher elektrischer bzw. magnetischer Feldstärke erfolgt, eine Empfindlichkeitsschwankung nicht ganz auszuschließen ist. Dieses Problem wird durch Neufestlegung d.h. Überschreiben des gespeicherten Wertes mit einem neuen Wert für den Schwellwert gelöst.

Gemäß einer bevorzugten Ausgestaltung ist vorgesehen, dass die Relativbewegung durch eine Drehbewegung hervorgerufen wird. Beispielsweise rotiert die erste Berührfläche im elektrischen Feld, das durch die Felderzeugungsmittel erzeugt wird.

Hinsichtlich der die Relativbewegung betreffenden Detektionseinrichtung ergibt sich keine erfindungsgemäße Einschränkung. Beispielsweise sind elektromechanische, oder berührungslos arbeitende, wie optische oder magnetische Mittel zur Detektion der Relativbewegung vorgesehen. Gemäß einer Ausgestaltung wird der Sensor zur Detektion der Relativbewegung herangezogen.

Um die Betriebssicherheit und die Zuverlässigkeit der Schwellwertermittlung insbesondere bei händischer Betätigung der Relativbewegung zu erhöhen, können verschiedene Maßnahmen oder Kombinationen dieser Maßnahmen vorgesehen sein, um zuverlässig auszuschließen, dass die Schwellwertermittlung erfolgt, während beispielsweise die Hand des Bedieners sich in der Nähe des Sensors oder gar auf der ersten Berührfläche befindet. Beispielsweise ist gemäß einer einfachen Ausgestaltung vorgesehen, dass die Kalibrierung in zeitlichem Abstand zur Bewegungsdetektion und Abschluss der Relativbewegung erfolgt.

Gemäß einer weiteren Ausgestaltung ist eine Abfolge von Schwellwertermittlungsschritte vorgesehen, um beispielsweise bei stark schwankenden Signalwerten, weil beispielsweise die Relativbewegung nicht abgeschlossen ist oder eine starke elektromagnetische Störung vorliegt, eine Speicherung zu verwerfen.

Gemäß einer weiteren bevorzugten Ausgestaltung ist ferner wenigstens ein weiterer berührungsempfindlicher Sensor vorgesehen. Beispielsweise handelt es sich um ein sogenanntes touchpad mit mehreren Sensoren zur ortsauflösenden Erfassung der Berührung. Der weitere Signalwert dieses wenigstens einen weiteren Sensors wird beim Schritt des Ermittelns ebenfalls ausgewertet. Beispielsweise wird der Speicherschritt nur durchgeführt wird, wenn dessen weiterer Signalwert auch in einen Bereich um dessen vorgespeicherten Schwellwert fällt. Gemäß einer weiteren Ausgestaltung wird die Summe aller Signalwerte mit der Summe aller vorgespeicherter Signalwerte verglichen.

Gemäß einer weiteren vorteilhaften Ausgestaltung weist der beim Kalibrieren berücksichtigte, wenigstens eine, weitere Sensor eine zugehörige weitere Berührfläche auf, die benachbart zur ersten Berührflache angeordnet ist, um mit hoher Zuverlässigkeit auszuschließen, dass eine Kalibrierung während einer Berührung der Berührflächen erfolgt. Bevorzugt werden die Berührflächen durch die gemeinsame Berührschicht definiert.

Gemäß einer weiteren Ausgestaltung ist vorgesehen, dass der vorgegebene Bereich in Abhängigkeit des Maßes der Lageänderung variiert.

Eine aus den obigen Gründen sich ergebende vorteilhafte Verwendung des erfindungsgemäßen Verfahrens in einer der zuvor beschriebenen Ausführungsformen betrifft die Verwendung in einem Kraftfahrzeug.

Die Erfindung betrifft ferner eine Bedieneinheit, die Folgendes aufweist einen berührempfindlichen Sensor, wobei der Sensor eine erste Berührfläche ausbildende Berührschicht und Mittel zur Erzeugung eines elektrischen Feldes im Bereich der ersten Berührfläche aufweist, um einen dem elektrischen Feld zugehörigen Induktivitäts- und/oder Kapazitätssignalwert mittels des Sensors zu erzeugen. Erfindungsgemäß sind die Berührschicht und die Mittel zur Erzeugung eines elektrischen Feldes relativ zueinander bewegbar. Die Bedieneinheit umfasst ferner eine Detektionseinrichtung, um eine Relativbewegung zwischen den Mitteln zur Erzeugung eines elektrischen Feldes und der Berührschicht zu detektieren. Ferner ist erfindungsgemäß eine Auswerteinheit vorgesehen, die ausgelegt ist, den Signalwert des Sensors mittels eines vorgespeicherten ersten Schwellwertes auszuwerten, um eine Berührung der ersten Berührfläche zu detektieren. Ferner ist die Auswerteinheit ausgelegt, nach Detektion einer Relativbewegung und bevorzugt, aber nicht zwingend, nach Abschluss der Relativbewegung das Kalibrierverfahren mit den folgenden Schritten durchzuführen: Ermitteln des dem elektrischen Feld zugehörigen Induktivitäts- und/oder Kapazitätssignalwertes; Vergleich des Signalwertes mit einem vorgespeicherten Schwellwert; Speichern des ermittelten Signalwertes als neuer Schwellwert, sofern wenigstens der gemessene Messwert in einen vorgegebenen Bereich um den vorgespeicherten Schwellwert fällt.

Der erfindungsgemäße Sensor umfasst Mittel zur Erzeugung eines elektrischen Feldes, beispielsweise eine oder mehrere Elektroden oder/oder eine Spule. Der erfindungsgemäße Sensor umfasst ferner eine Auswertschaltungsanordnung zur Ermittlung wenigstens einer Änderung der durch das elektrische Feld begründeten Induktivität und/oder Kapazität. Die Erfindung ist hinsichtlich des Sensors nicht eingeschränkt. Beispielsweise handelt es sich um einen kapazitiven Sensor. Die Auswertschaltungsanordnung umfasst beispielsweise wenigstens einen Mikrocontroller. Die Relativbewegung zwischen der Berührschicht und den Felderzeugungsmitteln kann beispielsweise mittels Aktuator erfolgen. Bevorzugt ist eine händisch betätigte Relativbewegung vorgesehen. Erfindungsgemäß umfasst das erfindungsgemäße Verfahren auch die Verwendung mehrerer Sensoren, wie eine räumliche Anordnung (Array) von Sensoren zur ortsauflösenden Erfassung der Berührung, beispielsweise ein touchpad oder ein touchscreen.

Das erfindungsgemäß Betriebsverfahren zeichnet sich dadurch aus, dass die Auswerteinheit so ausgelegt ist, dass nach erfolgter Detektion einer Relativbewegung zwischen den Mittel zur Erzeugung eines elektrischen Feldes (Messfeldes) und der Berührfläche eine Kalibrierung durchgeführt wird. Während die erfindungsgemäß eingeräumte Relativbewegung zwischen den Komponenten den gestalterischen und konstruktiven Freiraum verbessert und ferner bei ruhenden Felderzeugungsmitteln die Frage deren elektrischer Kontaktierung vereinfacht, so stellen die erfindungsgemäßen Kalibrierschritte die Funktionssicherheit sicher, da bei einer Relativbewegung, selbst wenn Sie im Wesentlichen in einer Ebene gleicher elektrischer bzw. magnetischer Feldstärke erfolgt, eine Empfindlichkeitsschwankung nicht ganz auszuschließen ist. Dieses Problem wird durch Neufestlegung d.h. Überschreiben des gespeicherten Wertes mit einem neuen Wert für den Schwellwert gelöst.

Bevorzugt ist die Bedieneinheit als Drehsteller ausgebildet und weist einen Drehknopf auf, wobei in den Drehknopf wenigstens die Berührschicht integriert ist und mit diesem mitbewegt wird.

Hinsichtlich der die Relativbewegung betreffenden Detektionseinrichtung ergibt sich keine erfindungsgemäße Einschränkung. Beispielsweise sind elektromechanische, oder berührungslos arbeitende, wie optische oder magnetische Mittel zur Detektion der Relativbewegung vorgesehen. Gemäß einer Ausgestaltung wird der Sensor zur Detektion der Relativbewegung herangezogen.

Gemäß einer weiteren bevorzugten Ausgestaltung ist ferner wenigstens ein weiterer berührungsempfindlicher Sensor vorgesehen. Beispielsweise handelt es sich um ein sogenanntes touchpad mit mehreren Sensoren zur ortsauflösenden Erfassung der Berührung. Der weitere Signalwert dieses wenigstens einen weiteren Sensors wird beim Schritt des Ermittelns ebenfalls ausgewertet. Beispielsweise wird der Speicherschritt nur durchgeführt wird, wenn dessen weiterer Signalwert auch in einen Bereich um dessen vorgespeicherten Schwellwert fällt. Gemäß einer weiteren Ausgestaltung wird die Summe aller Signalwerte mit der Summe aller vorgespeicherter Signalwerte verglichen.

Gemäß einer weiteren vorteilhaften Ausgestaltung weist der beim Kalibrieren berücksichtigte, wenigstens eine, weitere Sensor eine zugehörige weitere Berührfläche auf, die benachbart zur ersten Berührflache angeordnet ist, um mit hoher Zuverlässigkeit auszuschließen, dass eine Kalibrierung während einer Berührung der Berührflächen erfolgt. Die Berührflächen können einander überlappend, angrenzend oder zueinander beabstandet angeordnet sein.

Die Erfindung sowie das technische Umfeld werden nachfolgend anhand der Figur näher erläutert. Es ist darauf hinzuweisen, dass die Figur eine besonders bevorzugte Ausführungsvariante der Erfindung zeigt, diese jedoch nicht darauf beschränkt ist. Es zeigt schematisch:
- Fig. 1:: eine Schnittansicht der erfindungsgemäßen Bedieneinheit 1;
- Fig. 2:: eine Aufsicht in der erfindungsgemäßen Bedieneinheit 1 in Teilschnittdarstellung;
- Fig. 3:: ein Säulendiagramm aus den vorgespeicherten Schwellwerten der Sensoren gemäß einer Kalibrierung vor einer Drehung des Drehknopfes 2 der erfindungsgemäßen Bedieneinheit;
- Fig. 4a bis Fig. 4c:: jeweils ein Säulendiagramm aus den ermittelten Signalwerten nach Verdrehen des Drehknopfes,

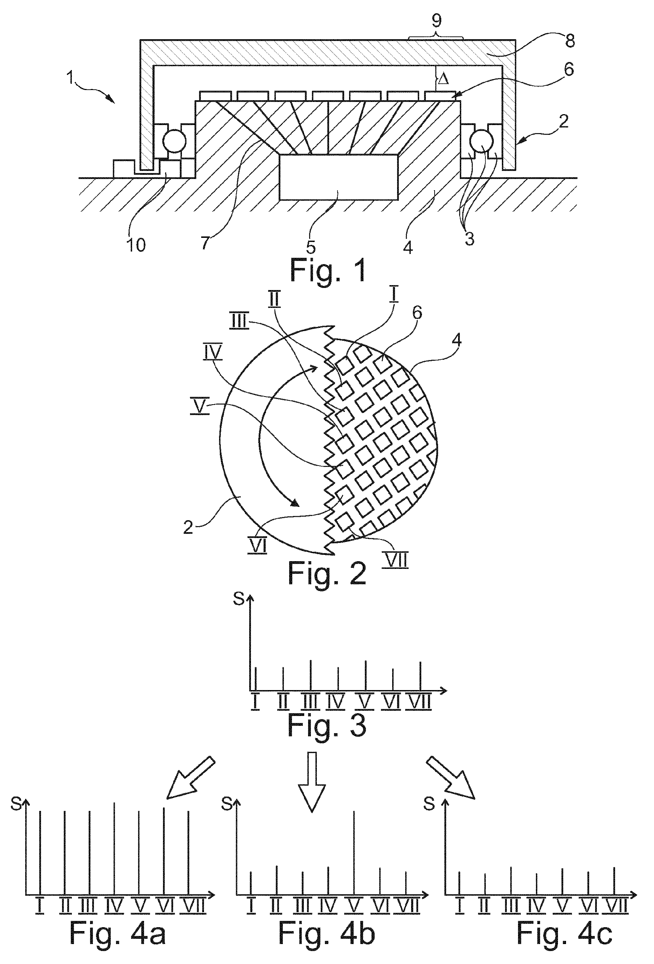

Figur 1 zeigt eine als Drehsteller ausgebildete erfindungsgemäße Bedieneinheit 1. Diese weist einen Drehknopf 2 aus, der mittels eines Kugellagers 3 drehbeweglich an einem Sockel 4 gelagert ist. Die Drehbewegung des Drehknopfes 2 wird mittels eines optischen Drehencoders 10 detektiert. Der Drehknopf 2 weist auf seiner Oberseite eine Berührschicht 8 auf. Die Berührschicht 8 definiert auf seiner dem Bediener zugewandten Seite mehrere einander teilweise überlappende Berührflächen 9 auf. Die Berührflächen 9 ergeben sich durch die mehreren Elektrodenflächen 6, die auf der Oberseite des Sockels 4 ausgebildet sind. Mittels jeder Elektrode 6 wird ein elektromagnetisches Feld erzeugt, dass jeweils die Berührfläche 9 durchdringt. Eine Berührung der jeweiligen Berührfläche wird dann detektiert, wenn die durch die Berührung bewirkte Kapazitätsänderung ein vorgegebenes Maß überschreitet, das durch Vergleich mit einem vorgespeicherten Wert ermittelt wird. Ein vorgespeicherter, d.h. in einem vorhergehenden Kalibrieren ermittelter Schwellwert ist in Figur 3 für die Sensoren I bis VII gezeigt. Die Auswertung, d.h. der Vergleich erfolgt mit einer Auswerteinheit 5, die über die elektrischen Leitungen 7 mit den mehreren Elektrodenflächen verbunden sind. Die mehrere, beabstandeten und elektrisch zueinander isolierten Elektrodenflächen 6 bilden wie in Figur 2 gezeigt ein Array aus. Wie in Figur 1 gezeigt, sind die Elektroden 6 über einen lichten Abstand Δ zur Berührschicht 8 beabstandet angeordnet. Aufgrund der durch Verdrehen des Drehknopfes 2 bewirkten Relativbewegung zwischen der Berührschicht 8 und den Elektroden 6 und der sich daraus ergebenden und nicht zu vermeidenden Schwankungen des lichten Abstandes Δ können sich Detektionsungenauigkeiten bei der Berührdetektion ergeben, wenn nicht ein erneutes Kalibrierverfahren gestartet wird. Somit wird nach erfolgter Detektion der Drehbewegung und deren Abschluss durch den Drehencoder 10 ein Kalibrieren durchgeführt. Die dabei ermittelten neuen Signalwerte werden mit den vorgespeicherten Schwellwerten verglichen. Fallen diese neuen Signalwerte in einen vorgegebenen Bereich um den vorgespeicherten Schwellenwert fallen, werden diese Signalwerte als neue Schwellwerte für die Sensoren I bis VII für die weitere Berührdetektion gespeichert, wie es bei Figur 4c gezeigt ist. Die Figuren 4a und 4b zeigen Situationen, bei denen der gemessene Signalwert der Sensoren I bis VII als neuer Schwellwert verworfen wird, weil beispielsweise wie in Fig. 4b der Signalwert eines Sensors V außerhalb des vorgegebenen Bereichs fällt oder wie in Fig. 4a alle Signalwerte der Sensoren I bis VII außerhalb des Bereichs um den vorgespeicherten Schwellwert liegen.

## Patentansprüche

1. Verfahren zum Betrieb eines berührempfindlichen Sensors, wobei der Sensor eine erste Berührfläche ausbildende Berührschicht und Mittel zur Erzeugung eines elektrischen Feldes im Bereich der ersten Berührfläche aufweist, um einen dem elektrischen Feld zugehörigen Induktivitäts- und/oder Kapazitätssignalwert mittels des Sensors zu erzeugen, und wobei die Berührschicht und die Mittel zur Erzeugung eines elektrischen Feldes relativ zueinander bewegbar sind; wobei das Verfahren die folgenden Schritte aufweist:
• Überwachen auf Detektion einer Relativbewegung zwischen den Mitteln zur Erzeugung eines elektrischen Feldes und der Berührschicht mittels einer Detektionseinrichtung;
• Bei und nach Detektion der Relativbewegung und bevorzugt nach Abschluss der Relativbewegung erfolgendes Kalibrieren: mit den Schritten
i. Ermitteln des dem elektrischen Feld zugehörigen Induktivitäts- und/oder Kapazitätssignalwertes mittels einer Auswerteinheit;
ii. Vergleich des Signalwertes mit einem vorgespeicherten Schwellwert mittels der Auswerteinheit;
iii. Speichern des ermittelten Signalwertes als neuer Schwellwert mittels der Auswerteinheit, sofern wenigstens der gemessene Signalwert in einen vorgegebenen Bereich um den vorgespeicherten Schwellwert fällt;
• nachfolgendes Auswerten des Signalwertes des Sensors mittels des gespeicherten Schwellwertes bis zur erneuten Detektion einer Relativbewegung durch die Auswerteinheit, um eine Berührung der ersten Berührfläche zu detektieren.

2. Verfahren gemäß dem vorhergehenden Anspruch, wobei die Relativbewegung durch eine Drehbewegung hervorgerufen wird.

3. Verfahren gemäß einem der vorhergehenden Ansprüche, wobei ferner wenigstens ein weiterer berührungsempfindlicher Sensor vorgesehen ist, dessen weiterer Signalwert beim Schritt des Ermittelns ausgewertet wird.

4. Verfahren gemäß dem vorhergehenden Anspruch, wobei der beim Kalibrieren berücksichtigte, wenigstens eine weitere Sensor eine zugehörige weitere, bevorzugt durch die Berührschicht ausgebildete, Berührfläche aufweist, die benachbart zur ersten Berührflache angeordnet ist.

5. Verfahren gemäß einem der beiden vorhergehenden Ansprüche, wobei der vorgegebene Bereich in Abhängigkeit des Maßes der Lageänderung variiert.

6. Verwendung des Verfahrens gemäß einem der vorhergehenden Ansprüche in einem Kraftfahrzeug.

7. Bedieneinheit (1), aufweisend einen berührempfindlichen Sensor, wobei der Sensor eine erste Berührfläche (9) ausbildende Berührschicht (8) und Mittel (6) zur Erzeugung eines elektrischen Feldes im Bereich der ersten Berührfläche aufweist, um einen dem elektrischen Feld zugehörigen Induktivitäts- und/oder Kapazitätssignalwert mittels des Sensors zu erzeugen, und wobei die Berührschicht (8) und die Mittel (6) zur Erzeugung eines elektrischen Feldes relativ zueinander bewegbar sind; ferner aufweisend eine Detektionseinrichtung (10), um eine Relativbewegung zwischen den Mitteln (6) zur Erzeugung eines elektrischen Feldes und der Berührschicht (8) zu detektieren, sowie eine Auswerteinheit (5), die ausgelegt ist, den Signalwert des Sensors mittels eines vorgespeicherten Schwellwertes auszuwerten, um eine Berührung der ersten Berührfläche (9) zu detektieren, **dadurch gekennzeichnet, dass** die Bedieneinheit dazu ausgebildet ist nach Detektion einer Relativbewegung und bevorzugt nach Abschluss der Relativbewegung ein Kalibrierverfahren mit den folgenden Schritten durchzuführen :
• Ermitteln des dem elektrischen Feld zugehörigen induktivitäts- und/oder Kapazitätssignalwertes;
• Vergleich des Signalwertes mit dem vorgespeicherten Schwellwert;
• Speichern des ermittelten Signalwertes als neuer Schwellwert, sofern wenigstens der gemessene Signalwert in einen vorgegebenen Bereich um den vorgespeicherten Schwellwert fällt;

8. Bedieneinheit (1) gemäß dem vorhergehenden Anspruch, wobei die Bedieneinheit als Drehsteller mit einem Drehknopf (2) ausgebildet ist und in den Drehknopf (2) wenigstens die Berührschicht (8) integriert ist.

9. Bedieneinheit (1) gemäß einem der beiden vorhergehenden Ansprüche, wobei ferner ein weiterer berührungsempfindlicher Sensor (I, II, III, IV, V, VI, VII)vorgesehen ist, dessen weiterer Signalwert beim Schritt des Ermittelns ausgewertet wird, und die Auswerteinheit (5) ausgelegt ist, den Speicherschritt nur durchzuführen, wenn bei einem weiteren Vergleichsschritt dessen weiterer Signalwert unter einem vorgespeicherten weiteren Schwellwert liegt.

10. Bedieneinheit (1) gemäß dem vorhergehenden Anspruch 9, wobei eine zweite, dem weiteren berührungsempfindlichen Sensor zugeordnete und bevorzugt von der Berührschicht (8) ausgebildete Berührfläche benachbart zur ersten Berührflache (9) angeordnet ist.

## Claims

1. A method for operating a touch-sensitive sensor, wherein the sensor has a touch layer forming a first touch panel and means for generating an electrical field in the region of the first touch panel in order to generate an inductance and/or conductance signal value associated with the electrical field by means of the sensor, and wherein the touch layer and the means for generating the electrical field are movable relative to each other; the method having the following steps:
• monitoring for the detection of a relative movement between the means for generating an electrical field and the touch layer by means of a detection device;
• calibration taking place during and after the detection of the relative movement, and preferably after the completion of the relative movement, comprising the steps:
i. determining the inductance and/or conductance signal value associated with the electrical field by means of an evaluation unit;
ii. comparing the signal value to a pre-stored threshold value by means of the evaluation unit;
iii. storing the determined signal value as the new threshold value by means of the evaluation unit if at least the measured signal value falls into a predefined range around the pre-stored threshold value;
• subsequently evaluating the signal value of the sensor by means of the stored threshold value until a new detection of a relative movement by the evaluation unit in order to detect a touch on the first touch panel.

2. The method according to the preceding claim, wherein the relative movement is caused by a rotary movement.

3. The method according to any one of the preceding claims, wherein, furthermore, at least one further touch-sensitive sensor is provided whose further signal value is evaluated during the determining step.

4. The method according to the preceding claim, wherein the at least one further sensor taken into account during calibration has an associated further touch panel, which is preferably formed by the touch layer and is disposed adjacent to the first touch panel.

5. The method according to any one of the two preceding claims, wherein the predefined range varies depending on the extent of the change in position.

6. Use of the method according to any one of the preceding claims in a motor vehicle.

7. An operating unit (1) having a touch-sensitive sensor, wherein the sensor has a touch layer (8) forming a first touch panel (9) and means (6) for generating an electrical field in the region of the first touch panel in order to generate an inductance and/or conductance signal value associated with the electrical field by means of the sensor, and wherein the touch layer (8) and the means (6) for generating the electrical field are movable relative to each other; further having a detection device (10) for detecting a relative movement between the means (6) for generating an electrical field and the touch layer (8), and an evaluation unit (5) configured to evaluate the signal value of the sensor by means of a pre-stored threshold value in order to detect a touch on the first touch panel (9), **characterized in that** the operating unit is configured to carry out, after the detection of a relative movement and preferably after the completion of the relative movement, a calibration method with the following steps:
• determining the inductance and/or conductance signal value associated with the electrical field;
• comparing the signal value to the pre-stored threshold value;
• storing the determined signal value as the new threshold value if at least the measured signal value falls into a predefined range around the pre-stored threshold value;

8. The operating unit (1) according to the preceding claim, wherein the operating unit is configured as a rotary actuator with a rotary knob (2), and at least the touch layer (8) is integrated into the rotary knob (2).

9. The operating unit (1) according to any one of the two preceding claims, wherein, furthermore, at least one further touch-sensitive sensor (I, II, III, IV, V, VI, VII) is provided whose further signal value is evaluated during the determining step, and the evaluation unit (5) is configured to carry the storage step only if, during a further comparing step, its signal value is below a pre-stored further threshold value.

10. The operating unit (1) according to the preceding claim 9, wherein a second touch panel, which is associated with the further touch-sensitive sensor and is preferably formed by the touch layer (8), is disposed adjacent to the first touch panel (9).

## Revendications

1. Procédé pour faire fonctionner un capteur tactile, dans lequel ledit capteur comprend une couche de contact formant première surface de contact et des moyens de génération d'un champ électrique au niveau de ladite première surface de contact afin de générer, au moyen du capteur, une valeur de signal d'inductance et/ou de capacité associée au champ électrique, et dans lequel ladite couche de contact et les moyens de génération d'un champ électrique sont déplaçables les uns par rapport aux autres; le procédé comprenant les étapes suivantes:
• surveillance quant à la détection d'un mouvement relatif entre les moyens de génération d'un champ électrique et la couche de contact au moyen d'un dispositif de détection;
• calibrage réalisé lors de et après la détection du mouvement relatif et de préférence après l'achèvement du mouvement relatif: comprenant les étapes consistant à
i. déterminer, au moyen d'une unité d'évaluation, la valeur de signal d'inductance et/ou de capacité associée au champ électrique;
ii. comparer, au moyen de l'unité d'évaluation, la valeur de signal à une valeur seuil mémorisée auparavant;
iii. mémoriser la valeur de signal déterminée en tant que nouvelle valeur seuil, au moyen de l'unité d'évaluation, si au moins la valeur de signal mesurée se situe dans une plage prédéterminée autour de la valeur seuil mémorisée auparavant;
• évaluation subséquente de la valeur de signal du capteur au moyen de la valeur seuil mémorisée, jusqu'à la nouvelle détection d'un mouvement relatif, par l'unité d'évaluation, pour détecter un contact de la première surface de contact.

2. Procédé selon la revendication précédente, dans lequel le mouvement relatif est provoqué par un mouvement de rotation.

3. Procédé selon l'une quelconque des revendications précédentes, dans lequel, en outre, au moins un autre capteur tactile est prévu dont l'autre valeur de signal est évaluée au cours de l'étape de détermination.

4. Procédé selon la revendication précédente, dans lequel ledit au moins un autre capteur pris en considération lors du calibrage présente une autre surface de contact associée qui est formée de préférence par la couche de contact et qui est disposée de manière voisine de la première surface de contact.

5. Procédé selon l'une quelconque des deux revendications précédentes, dans lequel la plage prédéterminée varie en fonction du degré du changement de position.

6. Utilisation du procédé selon l'une quelconque des revendications précédentes, dans un véhicule automobile.

7. Unité de commande (1) comprenant un capteur tactile, dans laquelle ledit capteur présente une couche de contact (8) formant première surface de contact (9) et des moyens (6) de génération d'un champ électrique au niveau de ladite première surface de contact afin de générer, au moyen du capteur, une valeur de signal d'inductance et/ou de capacité associée au champ électrique, et dans laquelle la couche de contact (8) et les moyens (6) de génération d'un champ électrique sont déplaçables les uns par rapport aux autres; comprenant en outre un dispositif de détection (10) pour détecter un mouvement relatif entre les moyens (6) de génération d'un champ électrique et ladite couche de contact (8), ainsi qu'une unité d'évaluation (5) qui est conçue pour évaluer la valeur de signal du capteur au moyen d'une valeur seuil mémorisée auparavant, pour détecter un contact de la première surface de contact (9), **caractérisée par le fait que** l'unité de commande est conçue pour mettre en oeuvre, après la détection d'un mouvement relatif et de préférence après l'achèvement du mouvement relatif, un procédé de calibrage comprenant les étapes suivantes consistant à:
• déterminer la valeur de signal d'inductance et/ou de capacité associée au champ électrique;
• comparer la valeur de signal à la valeur seuil mémorisée auparavant;
• mémoriser la valeur de signal déterminée en tant que nouvelle valeur seuil, si au moins la valeur de signal mesurée se situe dans une plage prédéterminée autour de la valeur seuil mémorisée auparavant.

8. Unité de commande (1) selon la revendication précédente, dans laquelle l'unité de commande est réalisée comme actionneur rotatif comprenant un bouton rotatif (2), et au moins la couche de contact (8) est intégrée au bouton rotatif (2).

9. Unité de commande (1) selon l'une quelconque des deux revendications précédentes, dans laquelle, en outre, un autre capteur tactile (I, II, III, IV, V, VI, VII) est prévu dont l'autre valeur de signal est évaluée lors de l'étape de détermination, et l'unité d'évaluation (5) est adaptée pour ne mettre en oeuvre l'étape de mémorisation que lorsque, au cours d'une autre étape de comparaison, son autre valeur de signal est inférieure à une autre valeur seuil mémorisée auparavant.

10. Unité de commande (1) selon la revendication précédente 9, dans laquelle une deuxième surface de contact qui est associée à l'autre capteur tactile et est formée, de préférence, par la couche de contact (8) est disposée de manière voisine de la première surface de contact (9).
